# EUROPEAN PATENT APPLICATION

(11) **EP 4 819 167 A1**
(43) Date of publication of application: **07.10.2026**
(21) Application number: 24897047.7
(22) Date of filing: 20.09.2024
(51) Int. Cl.: G21H 1/10, H10N 15/20

(54) **NUCLEAR BATTERY**

(30) Priority: 30.11.2023 JP 2023203042
(71) Applicant: SUMITOMO CHEMICAL COMPANY, LIMITED, Tokyo 103-6020 (JP); THE UNIVERSITY OF TOKYO, Tokyo 113-8654 (JP)
(72) Inventor: OKAMOTO, Satoshi, Tokyo 103-6020 (JP); SAITOH, Eiji, Tokyo 113-8654 (JP)
(74) Representative: J A Kemp LLP
(86) International application number: PCT/JP2024/033618
(87) International publication number: WO 2025/115356

(57) **Abstract**

The problem is to providing a nuclear battery that is lightweight and can realize thickness reduction. The problem is solved by a nuclear battery comprising a thermoelectric conversion element provided with: a thermoelectric conversion unit exhibiting non-reciprocal conduction based on breakage of space inversion symmetry; and a pair of electrodes for extracting a non-reciprocal thermoelectric signal, that are arranged apart from each other on the thermoelectric conversion unit, at least one constituent of the nuclear battery containing a radioisotope element.

## Description

### TECHNICAL FIELD

The present invention relates to a nuclear battery capable of extracting electrical energy from decay heat by containing a radioisotope element.

### BACKGROUND ART

Fuels for nuclear power generation contain radioisotopes even after use, and constantly release nuclear decay heat; therefore, long-term management of such fuels is an extremely important issue. If there are a way to effectively convert the thermal energy and utilize it as electricity, it can be considered an extremely stable power source that can operate over an extended period. In fact, deep-space probes that cannot use solar power are equipped with radioisotope batteries in which radioisotopes and thermoelectric elements are combined, and such deep-space probes have been supporting decades-long missions, continuously transmitting images of deep space back to Earth to this day.

As a conventional technology, radioisotope thermoelectric generators (RTG : Radioisotope thermoelectric generator) are used. can extract Electricity can be extracted from radioactive decay.They use thermocouples and convert the decay heat of radioactive materials into electricity through the Seebeck effect.

For example, Patent Document 1 discloses a nuclear battery with little degradation due to radiation and can be made compact.

### CITATION LIST

### PATENT LITERATURE

[PTL 1]
Japanese Unexamined Patent Application Publication No. 2021-85774

### SUMMARY OF THE INVENTION

### TECHNICAL PROBLEM

The nuclear battery disclosed in Patent Document 1 requires cooling since it utilizes a temperature gradient, resulting in the apparatus in a large-scale. Therefore, a further reduction in weight and thickness is desired.

The present disclosure was made in view of the above-described circumstances, and an object of the present disclosure is to provide a nuclear battery that is lightweight and can realize thickness reduction.

### SOLUTION TO PROBLEM

As a result of intensive studies, the present inventors discovered that a thermoelectric conversion element capable of performing thermoelectric conversion from temperature fluctuations at the microscale can be provided by a thermoelectric conversion element which includes a thermoelectric conversion unit exhibiting non-reciprocal conduction based on breakage of space inversion symmetry, and a pair of electrodes that are arranged apart from each other on the thermoelectric conversion unit and used for extracting a non-reciprocal thermoelectric signal. Further, in a nuclear battery equipped with the thermoelectric conversion element, the present inventors incorporated a radioisotope into at least one of the constituents of the nuclear battery, thereby arriving at a nuclear battery that is lightweight and can be made thin.

That is, one aspect of the present disclosure relates to a nuclear battery comprising a thermoelectric conversion element provided with:
a thermoelectric conversion unit exhibiting non-reciprocal conduction based on breakage of space inversion symmetry; and
a pair of electrodes for extracting a non-reciprocal thermoelectric signal, that are arranged apart from each other on the thermoelectric conversion unit,
at least one constituent of the nuclear battery containing a radioisotope element.

In the present disclosure, it is preferred an aspect in which the thermoelectric conversion unit is a thermoelectric conversion layer including a ferromagnetic metal layer and a paramagnetic metal layer that are stacked on each other, and the pair of electrodes are arranged apart from each other on the thermoelectric conversion layer in an in-plane direction of the thermoelectric conversion layer,. According to the aspect, since the voltage of the thermoelectric conversion based on breakage of space inversion symmetry of the thermoelectric conversion layer is increased, the power generation efficiency of the nuclear battery isparticularly increased.

In the present disclosure, it is preferred an aspect in which the separation distance between the pair of electrodes is 0.1 µm or more and 1,000 µm or less. By setting the separation distance in this range, since the voltage of the thermoelectric conversion is increased, the power generation efficiency of the nuclear battery is increased.

In the present disclosure, it is preferred an aspect in which the paramagnetic metal layer is composed of a single layer or plural stacked layers, and the single layer or each of the plural stacked layers of the paramagnetic metal layer is composed of Pt, Pd, W, an AuW alloy, Ta, a CuIr alloy, a CuBi alloy, a BiSb alloy, or a BiSe alloy is preferred. According to the aspect, since the non-reciprocity of the conduction based on breakage of space inversion symmetry of the thermoelectric conversion layer is particularly increased, the power generation efficiency of the nuclear battery is particularly increased.

In the present disclosure, it is preferred an aspect in which the ferromagnetic metal layer is composed of a single layer or plural stacked layers, and the single layer or each of the plural stacked layers of the ferromagnetic metal layer is composed of a Ni-Fe alloy, Fe, Co, Ni, Gd, a CoFeB alloy, or a (Ga,Fe)Sb alloy. These materials exhibit ferromagnetism at room temperature and, since non-reciprocity of conduction at room temperature is realized, the power generation efficiency of the nuclear battery is increased.

In the present disclosure, it is preferred an aspect in which the radioisotope element contains at least one element selected from the group consisting of beryllium-10, carbon-14, aluminum-26, silicon-32, chlorine-36, argon-39, potassium-40, nickel-63, selenium-79, rubidium-87, zirconium-93, indium-115, cesium-137, lanthanum-138, niobium-94, technetium-98, lutetium-71, neodymium-144, samarium-146, samarium-147, gadolinium-152, platinum-190, bismuth-210, polonium-209, thorium-232, uranium-232, uranium-233, uranium-234, uranium-235, uranium-236, uranium-238, plutonium-236, plutonium-238, plutonium-239, plutonium-244, americium-241, americium-243, curium-244, curium-246, curium-247, curium-248, californium-249, and californium-251. By using these radioisotope elements, the power generation efficiency of the nuclear battery is particularly increased.

Another aspect of the present disclosure is a nuclear battery module including a plurality of any of the above-described nuclear batteries, in which the plurality of the nuclear batteries are electrically connected to each other such that non-reciprocal thermoelectric signals from the respective nuclear batteries can be superimposed with the same polarity. This enables extraction of a large non-reciprocal thermoelectric signal, so that the power generation efficiency of the nuclear batteries is increased.

### ADVANTAGEOUS EFFECTS OF INVENTION

According to the present disclosure, a nuclear battery that is lightweight and can realize thickness reduction can be provided.

According to the thermoelectric conversion element included in the nuclear battery of the present disclosure, a thermoelectric signal generated by inflow of a heat flow in the thermoelectric conversion unit is non-reciprocal with respect to the direction of the heat flow due to non-reciprocal conduction of the thermoelectric conversion unit, and such a non-reciprocal thermoelectric signal can be electrically extracted by the pair of electrodes.

More specifically, when a heat flow inflows into a laminate of the ferromagnetic metal layer magnetized by application of a magnetic field of 1 T or less and the paramagnetic metal layer, a spin current is driven in the paramagnetic metal layer, and spin accumulation is formed at the interface between the paramagnetic metal layer and the ferromagnetic metal layer. The polarity of this spin accumulation is parallel or antiparallel to the magnetization direction of the ferromagnetic metal layer, depending on the direction of the heat flow. Electron scattering changes in accordance with the relative direction between the polarity of the spin accumulation and the magnetization direction, and this causes a thermoelectric signal generated in the thermoelectric conversion layer to be dependent on the direction of the heat flow, i.e., non-reciprocity. This is a non-reciprocal thermoelectric signal, and such a non-reciprocal thermoelectric signal can be electrically extracted by the pair of electrodes. Therefore, even from a heat flow whose direction or magnitude changes randomly, a thermoelectric signal can be generated in a certain direction inside the paramagnetic metal layer, making it possible to perform thermoelectric conversion from temperature fluctuations at the microscale.

By using such a thermoelectric conversion element, a nuclear battery that is lightweight and can realize thickness reduction can be provided.

### BRIEF DESCRIPTION OF DRAWINGS

[FIG. 1] FIG. 1 is a schematic cross-sectional view illustrating one aspect of the nuclear battery.
[FIG. 2] FIG. 2 is a schematic cross-sectional view illustrating one aspect of the nuclear battery.
[FIG. 3] FIG. 3 is a perspective view illustrating the thermoelectric conversion element according to one embodiment.
[FIG. 4] FIG. 4 is a cross-sectional view of the thermoelectric conversion element according to one embodiment.
[FIG. 5] FIG. 5 is a flow chart showing the steps of the thermoelectric conversion method according to one embodiment.
[FIG. 6] FIG. 6 is a perspective view illustrating the configuration of the thermoelectric conversion module using the thermoelectric conversion element.
[FIG. 7] FIG. 7 is a schematic view of the nuclear battery according to Examples.

### DESCRIPTION OF EMBODIMENTS

Aspects for carrying out the present invention will now be described in detail referring to the attached drawings. In each drawing, where possible, the same symbol is used for identical elements. Further, the dimensional ratios within a constituent and between constituents in the drawings are arbitrarily set for the sake of the ease of viewing the drawings.

One aspect of the present disclosure is a nuclear battery comprising a thermoelectric conversion element provided with: a thermoelectric conversion unit exhibiting non-reciprocal conduction based on breakage of space inversion symmetry; and a pair of electrodes for extracting a non-reciprocal thermoelectric signal, that are arranged apart from each other on the thermoelectric conversion unit.

### <Thermoelectric Conversion Unit>

The thermoelectric conversion unit is a thermoelectric conversion element that exhibits non-reciprocal conduction based on breakage of space inversion symmetry. The material constituting the thermoelectric conversion unit is not particularly limited as long as it exhibits non-reciprocal conduction based on breakage of space inversion symmetry, however, it typically includes a laminate of a ferromagnetic metal layer and a paramagnetic metal layer that are stacked on each other.

In this laminate, the paramagnetic metal layer is arranged on one surface of the ferromagnetic metal layer, however, the same paramagnetic metal layer is not arranged on the other surface of the ferromagnetic metal layer, and the ferromagnetic metal layer is arranged on one surface of the paramagnetic metal layer, however, the same ferromagnetic metal layer is not arranged on the other surface of the paramagnetic metal layer. Therefore, the laminate of the ferromagnetic metal layer and the paramagnetic metal layer that are stacked on each other has a structure in which space inversion symmetry is broken along the stacking direction. The laminate substantially has space inversion symmetry in the plane direction. Further, due to the breakage of space inversion symmetry along the stacking direction, the laminate exhibits non-reciprocity in terms of electric conductivity in the plane direction.

The ferromagnetic metal layer is composed of a metal that exhibits ferromagnetism at the temperature of the usage environment of the nuclear battery. The ferromagnetic metal layer is preferably composed of a metal that exhibits ferromagnetism at room temperature (about 300 K) and, from this standpoint, the ferromagnetic metal layer is preferably composed of Fe, Co, Ni, Gd, or an alloy containing at least one of these metals, and is particularly preferably composed of a Ni-Fe alloy, Co, or CoFeB.

The thickness of the ferromagnetic metal layer is not particularly limited but may be, for example, 1 nm or more and 100 nm or less.

The paramagnetic metal layer is composed of a metal that exhibits paramagnetism at the temperature of the usage environment of the nuclear battery, and is preferably composed of a metal that exhibits paramagnetism at room temperature (about 300 K). The paramagnetic metal layer is preferably composed of a paramagnetic metal with high spin-orbit interaction so as to increase the below-described spin Nernst effect in the paramagnetic metal layer and, from this standpoint, the paramagnetic metal layer is preferably composed of Pt, Pd, W, an AuW alloy, Ta, a CuIr alloy, a CuBi alloy, a BiSb alloy, or a BiSe alloy, and is particularly preferably composed of Pt.

The thickness of the paramagnetic metal layer is not particularly limited and may be, for example, 1 nm or more and 100 nm or less.

### <Electrodes>

The electrodes are arranged apart from each other on the thermoelectric conversion unit, and extract a non-reciprocal thermoelectric signal from the thermoelectric conversion unit. The arrangement of the electrodes is not particularly limited as long as the electrodes can extract a non-reciprocal thermoelectric signal from the thermoelectric conversion unit, and, the electrodes are typically arranged apart on the surface of the thermoelectric conversion unit.

When the pair of electrodes are arranged apart from each other on the surface of the thermoelectric conversion unit, the separation distance between the electrodes in the planar direction of the thermoelectric conversion unit is preferably 0.1 µm or more and 1,000 µm or less. The thickness of the electrodes is not particularly limited and may be, for example, 10 nm or more and 1 µm or less.

The electrodes are composed of a material having an electro conductivity capable of extracting a non-reciprocal thermoelectric signal from the thermoelectric conversion layer, and examples of such a material include: metal materials such as Cu, Ag, Au, Pt, Ni, Al, constantan, Cr, In, Pd, Fe, Cu alloys, Ti/Au laminates, and Cr/Au laminates; and conductive oxides, such as indium tin oxide (ITO) and zinc oxide (ZnO), and thereamong, Cu, Ag, Au, Pt, Ni, Al, constantan, and Cu alloys are preferred, and Cu, Au, Ag, Pt, Ni, Ti/Au laminates, and Cr/Au laminates are particularly preferred.

### <Substrate>

The nuclear battery may include a substrate that supports the thermoelectric conversion unit. The shape of the substrate is not particularly limited, and the substrate may be in the form of a plate or a film. The material of the substrate is also not particularly limited, and examples thereof include: metals such as Au, Ag, Cu, and Al; silicon; sapphire; SiC; GaN; yttria-stabilized zirconia (YSZ); and resins such as polyimide, polyethylene terephthalate (PET), and polyethylene naphthalate (PEN).

### <Method of Producing Thermoelectric Conversion unit>

The thermoelectric conversion unit is formed by, for example, preparing a substrate, depositing a material for forming the ferromagnetic metal layer and a material for forming the paramagnetic metal layer in this order on the surface of the substrate by a physical vapor deposition method such as DC magnetron sputtering, to form a laminate, and then patterning the thus formed laminate into a rectangular shape in a plan view by a photolithography method and a lift-off method. Thereafter, a metal material for forming the pair of electrodes is deposited in a region including the surface of the paramagnetic metal layer by a physical vapor deposition method such as DC magnetron sputtering, to form a metal layer, which is then patterned into a prescribed shape by a photolithography method and a lift-off method to form the pair of electrodes. It is noted here that the order of depositing the ferromagnetic metal layer and the paramagnetic metal layer on the substrate may be reversed. Further, metal layers serving as the electrodes may be formed on the substrate first, and then the ferromagnetic metal layer and the paramagnetic metal layer may be deposited thereon.

The thermoelectric conversion unit may also include a layer comprising an insulating magnetic material and arranged in contact with the ferromagnetic metal layer.

### <Radioisotope>

In the nuclear battery of the present disclosure, at least one constituent of the nuclear battery contains a radioisotope. The radioisotope may be any isotope capable of emitting radiation, and examples thereof include beryllium-10, carbon-14, aluminum-26, silicon-32, chlorine-36, argon-39, potassium-40, nickel-63, selenium-79, rubidium-87, zirconium-93, indium-115, cesium-137, lanthanum-138, niobium-94, technetium-98, lutetium-71, neodymium-144, samarium-146, samarium-147, gadolinium-152, platinum-190, bismuth-210, polonium-209, thorium-232, uranium-232, uranium-233, uranium-234, uranium-235, uranium-236, uranium-238, plutonium-236, plutonium-238, plutonium-239, plutonium-244, americium-241, americium-243, curium-244, curium-246, curium-247, curium-248, californium-249, and californium-251. .Thereamong, plutonium-238 and curium-244 are preferred.

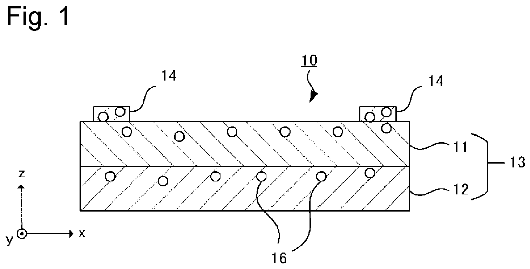

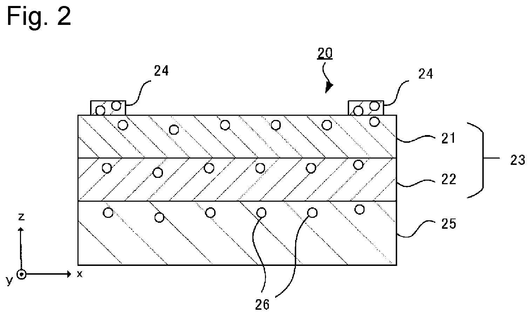

The radioisotope is contained in at least one constituent of the nuclear battery. Specific examples thereof will now be described with reference to FIG. 1 and FIG.2.

FIG. 1 shows a schematic cross-sectional view of a nuclear battery, the constituents of which are: a thermoelectric conversion unit comprising a paramagnetic metal layer and a ferromagnetic metal layer; and a pair of electrodes. In FIG. 1, a radioisotope 16 is contained in all of the constituents of a nuclear battery 10, i.e., all of the paramagnetic metal layer 11, the ferromagnetic metal layer 12, and the pair of electrodes 14.

A method for incorporating the radioisotope into the constituents is not particularly limited, and any known method may be employed as appropriate. For example, a method of implanting the radioisotope into the constituents by using an accelerator or the like, can be mentioned.

Examples of other arrangement of the radioisotope in the nuclear battery having the constituents illustrated in FIG. 1 include:
- the radioisotope is arranged only in the electrodes;
- the radioisotope is arranged only in the paramagnetic metal layer;
- the radioisotope is arranged only in the ferromagnetic metal layer;
- the radioisotope is arranged in the electrodes and the paramagnetic metal layer;
- the radioisotope is arranged in the electrodes and the ferromagnetic metal layer; and
- the radioisotope is arranged in the paramagnetic metal layer and the ferromagnetic metal layer.

FIG. 2 shows a schematic cross-sectional view of a nuclear battery, the constituents of which are: a thermoelectric conversion unit consisting of a paramagnetic metal layer and a ferromagnetic metal layer; a pair of electrodes; and a substrate. In FIG. 2, a radioisotope 26 is contained in all of the constituents of a nuclear battery 20, i.e., all of a paramagnetic metal layer 21, a ferromagnetic metal layer 22, a pair of electrodes 24, and a substrate 25.

Examples of other arrangement of the radioisotope in the nuclear battery having the constituents illustrated in FIG. 2 include:
- the radioisotope is arranged only in the electrodes;
- the radioisotope is arranged only in the paramagnetic metal layer;
- the radioisotope is arranged only in the ferromagnetic metal layer;
- the radioisotope is arranged only in the substrate;
- the radioisotope is arranged in the electrodes and the paramagnetic metal layer;
- the radioisotope is arranged in the electrodes and the ferromagnetic metal layer;
- the radioisotope is arranged in the electrodes and the substrate;
- the radioisotope is arranged in the paramagnetic metal layer and the ferromagnetic metal layer;
- the radioisotope is arranged in the paramagnetic metal layer and the substrate;
- the radioisotope is arranged in the ferromagnetic metal layer and the substrate;
- the radioisotope is arranged in the electrodes, the paramagnetic metal layer, and the ferromagnetic metal layer;
- the radioisotope is arranged in the electrodes, the paramagnetic metal layer, and the substrate;
- the radioisotope is arranged in the electrodes, the ferromagnetic metal layer, and the substrate; and
- the radioisotope is arranged in the paramagnetic metal layer, the ferromagnetic metal layer, and the substrate.

As described above, the radioisotope element may be contained in any of the constituents of the nuclear battery. This is based on that the thermoelectric conversion unit included in the nuclear battery of the present disclosure generates electricity by the spin Nernst effect as described below rather than generating electricity by the spin Seebeck effect as disclosed in Patent Document 1, and that there is thus no need to create a temperature gradient in the stacking direction for the thermoelectric conversion element.

Therefore, it is not required to adopt a form in which the radioisotope element is arranged only on one side of the stacking direction of the thermoelectric conversion unit. Specifically, it is not necessary to adopt a form in which the thermoelectric conversion unit, the substrate, and the radioisotope layer are stacked in this order, or a form in which the radioisotope layer, the thermoelectric conversion unit, and the substrate are stacked in this order.

Further, it is not required to arrange the radioisotope in such a manner that the radioisotope creates a temperature gradient for generating the spin Seebeck effect in the thermoelectric conversion unit.

Moreover, the nuclear battery may take a form in which plural radioisotope elements are randomly distributed in the constituents and/or across multiple members. In other words, the radioisotope element is not required to be arranged as a radioisotope layer.

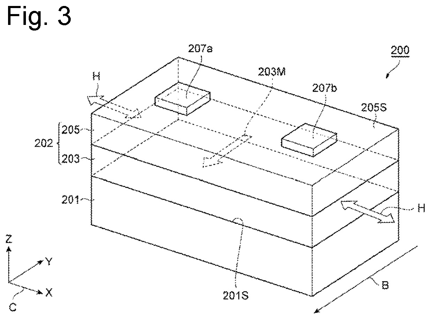

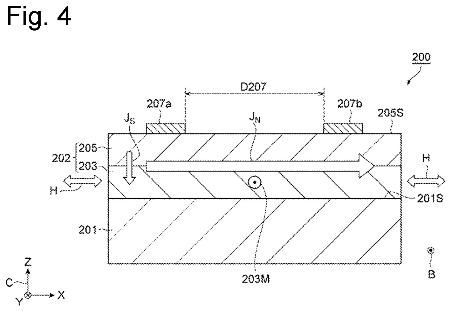

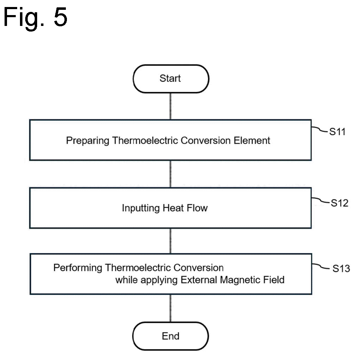

Next, the thermoelectric conversion method according to the present embodiment will be described. FIG. 5 is a flow chart showing the steps of the thermoelectric conversion method according to the present embodiment. As shown in FIG. 5, the thermoelectric conversion method according to the present embodiment includes: a step S11 of preparing a thermoelectric conversion element; a step S12 of inputting a heat flow; and a step S13 of performing thermoelectric conversion while applying an external magnetic field. These steps will now be described with reference to FIG. 3 and FIG. 4.

In the step S11 of preparing a thermoelectric conversion element, a thermoelectric conversion element 200 illustrated in FIGs. 3 and 4 is prepared. Subsequently, in the step S12 of inputting a heat flow, an external heat flow H, which is the subject of thermoelectric conversion, is input to a thermoelectric conversion layer 202 such that it flows along the X-axis direction, which is an in-plane (XY planar) direction of the thermoelectric conversion layer 202.

Next, in the step S13 of performing thermoelectric conversion while applying an external magnetic field, an external magnetic field B generated by a magnetic field generating unit provided outside the thermoelectric conversion element 200 is applied to a ferromagnetic metal layer 203. In this process, the application direction of the external magnetic field B is the Y-axis negative direction, which is an in-plane (XY planar) direction of the thermoelectric conversion element 200 and one of the directions perpendicular to the flow direction of the heat flow H. As a result, the ferromagnetic metal layer 203 is magnetized in the direction of the external magnetic field B, and has magnetization 203M oriented in the direction of the external magnetic field B. This application of the external magnetic field B is maintained during the thermoelectric conversion of the heat flow H. The magnitude of the external magnetic field B can be, for example, 1 T or less.

In the step S13, when the heat flow H flows into a paramagnetic metal layer 205, a spin current J_{S} is generated along the Z-axis direction and flows into the ferromagnetic metal layer 203. The polarity of the spin current J_{S} shifts to the Y-axis positive direction or the Y-axis negative direction depending on the direction of the heat flow H. Therefore, when the direction of the heat flow H is reversed, the polarity of the spin current J_{S} is reversed, so that the relative orientation relationship between the polarity of the spin current J_{S} and the direction of the magnetization 203M of the ferromagnetic metal layer 203 is reversed. Further, the relative orientation relationship between the polarity of the spin current J_{S} and the direction of the magnetization 203M can also be reversed by reversing the direction of the magnetization 203M of the ferromagnetic metal layer 203.

When the spin current J_{S} flows into the ferromagnetic metal layer 203, electron scattering changes in accordance with the relative orientation between the direction of the polarity of the spin current and the direction of the magnetization 203M of the ferromagnetic metal layer 203. Since the direction of the polarity of the spin current in the vicinity of the bonding interface between the ferromagnetic metal layer 203 and the paramagnetic metal layer 205 changes depending on the direction of the heat flow H, the electron scattering changes depending on the direction of the heat flow H. This causes a thermoelectric signal generated in the thermoelectric conversion layer 202 to be dependent on the direction of the heat flow H, i.e., non-reciprocity.

The present inventors discovered that a thermoelectric signal J_{N} generated in the thermoelectric conversion layer 202 in this manner is non-reciprocal with respect to the direction of the heat flow H due to the above-described non-reciprocal conduction of the thermoelectric conversion layer 202 (i.e., the thermoelectric signal J_{N} changes nonlinearly with respect to the direction of the heat flow H), and the direction of the thermoelectric signal J_{N} is the X-axis positive direction regardless of whether the direction of the heat flow H is the X-axis positive direction or the X-axis negative direction; and that such a non-reciprocal thermoelectric signal J_{N} can be electrically extracted via a pair of electrodes 207a and 207b. Therefore, according to the thermoelectric conversion element 200 of the present embodiment, even with random changes in the direction and the magnitude of the heat flow H, the non-reciprocal thermoelectric signal J_{N} can be generated in a certain direction inside the thermoelectric conversion layer 202, making it possible to perform thermoelectric conversion from temperature fluctuations at the microscale.

Further, by reversing the direction of the external magnetic field B to the Y-axis positive direction and thereby reversing the direction of the magnetization 203M of the ferromagnetic metal layer 203 to the Y-axis positive direction, the direction of the non-reciprocal thermoelectric signal J_{N} can be reversed to the X-axis negative direction.

In the thermoelectric conversion layer 202, when the magnitude of the voltage of the non-reciprocal thermoelectric signal J_{N} extracted by the pair of electrodes 207a and 207b is denoted as V, an electric field that is generated in the thermoelectric conversion layer 202 and corresponds to V is denoted as E, the non-linear Seebeck coefficient of the thermoelectric conversion layer 202 is denoted as S, the distance between the pair of electrodes 207a and 207b is denoted as L (D207 in FIG. 4), a temperature gradient over the range of the distance L in the thermoelectric conversion layer 202 is denoted as ∇T, and a temperature difference over the range of the distance L in the thermoelectric conversion layer 202 is denoted as ΔT, a relationship of electric field E = non-linear Seebeck coefficient S × (temperature gradient ∇T)² is established. Multiplication of both sides of this equation by the distance L yields voltage V = non-linear Seebeck coefficient S × (temperature difference ΔT)²/L; therefore, the smaller the distance L between the pair of electrodes 207a and 207b, the larger is the voltage V. Accordingly, by controlling the separation distance D207 between the pair of electrodes 207a and 207b in the X-axis direction to be a small value of preferably 1,000 µm or less as described above, the non-reciprocal thermoelectric signal J_{N} extracted by the pair of electrodes 207a and 207b is amplified.

The thermoelectric conversion element 200 may also include a heat conduction section that is arranged in contact with or close proximity to the end face on the X-axis positive side and/or the end face on the X-axis negative side for the purpose of facilitating the flow of the heat flow H into the thermoelectric conversion layer 202. Such a heat conduction section may be composed of, for example, aluminum, copper, carbon fiber, sapphire, alumina, silicon with a thermal oxide film, or a high-molecular-weight polymer.

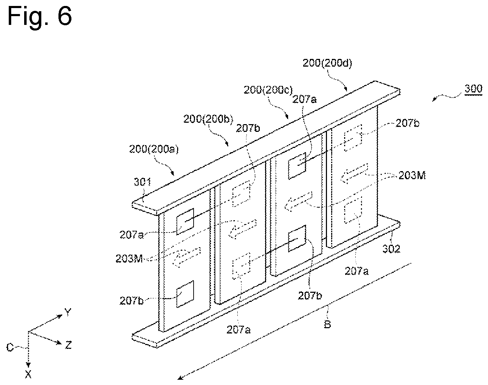

FIG. 6 is a perspective view illustrating the configuration of a thermoelectric conversion module using the above-described thermoelectric conversion element. As illustrated in FIG. 6, a thermoelectric conversion module 300 according to the present embodiment includes plural thermoelectric conversion elements 200 and, in this embodiment, the thermoelectric conversion module 300 includes four thermoelectric conversion elements 200a, 200b, 200c, and 200d. The four thermoelectric conversion elements 200a, 200b, 200c, and 200d are electrically connected to each other such that non-reciprocal thermoelectric signals J_{N} from the respective thermoelectric conversion elements are superimposed with the same polarity.

Specifically, in the thermoelectric conversion module 300, the thermoelectric conversion elements 200a and 200c, which are arranged in a Cartesian coordinate system C in the same mode as the thermoelectric conversion element 200 illustrated in FIG. 3 and FIG. 4, and the thermoelectric conversion elements 200b and 200d, which are arranged in the Cartesian coordinate system C in a mode in which the thermoelectric conversion element 200 illustrated in FIG. 3 and FIG. 4 is rotated 180° about the Y-axis, are alternately provided along the Y-axis direction. The electrode 207a of the thermoelectric conversion element 200a and the electrode 207b of the thermoelectric conversion element 200b are electrically connected, the electrode 207a of the thermoelectric conversion element 200b and the electrode 207b of the thermoelectric conversion element 200c are electrically connected, and the electrode 207a of the thermoelectric conversion element 200c and the electrode 207b of the thermoelectric conversion element 200d are electrically connected. Alternatively, instead of arranging the thermoelectric conversion elements 200b and 200d in a mode of being rotated 180° about the Y-axis, the thermoelectric conversion elements 200b and 200d may be arranged in the Cartesian coordinate system C in the same manner as the thermoelectric conversion elements 200a and 200c and in the same mode as the thermoelectric conversion element 200 illustrated in FIG. 3 and FIG. 4, and the stacking order of the ferromagnetic metal layer 203 and the paramagnetic metal layer 205 of the thermoelectric conversion layer 202 may be reversed in the thermoelectric conversion elements 200b and 200d. In this case, the electrode 207a of the thermoelectric conversion element 200a and the electrode 207a of the thermoelectric conversion element 200b are electrically connected, the electrode 207b of the thermoelectric conversion element 200b and the electrode 207b of the thermoelectric conversion element 200c are electrically connected, and the electrode 207a of the thermoelectric conversion element 200c and the electrode 207a of the thermoelectric conversion element 200d are electrically connected.

The ferromagnetic metal layers 203 of the four thermoelectric conversion elements 200a, 200b, 200c, and 200d are magnetized in the Y-axis negative direction by the external magnetic field B, and have magnetization 203M oriented in the Y-axis negative direction.

Further, the thermoelectric conversion module 300 includes heat conduction sections 301 and 302 that are arranged in contact with or close proximity to the end faces on the X-axis negative side and the end faces on the X-axis positive side of the four thermoelectric conversion elements 200a, 200b, 200c, and 200d. This facilitates the heat flow flowing in the X-axis direction to flow into the respective ferromagnetic metal layers 203 of the four thermoelectric conversion elements 200a, 200b, 200c, and 200d. The thermoelectric conversion module 300 does not have to include the heat conduction sections 301 and 302.

Non-reciprocal thermoelectric signals, which are generated in the respective thermoelectric conversion elements 200 as a result of the flow of the heat flow into the respective ferromagnetic metal layers 203 of the four thermoelectric conversion elements 200a, 200b, 200c, and 200d, can be superimposed with the same polarity and then extracted by the electrode 207b of the thermoelectric conversion element 200a and the electrode 207a of the thermoelectric conversion element 200d; therefore, a large non-reciprocal thermoelectric signal can be extracted.

The nuclear battery may include a shield formed of a radiation-shielding member. The shield is provided for the purpose of preventing radiation emitted from the radioisotope element from being released into the external environment; therefore, the shield may be provided as a layer on the outermost surface of the nuclear battery, or as a casing that covers the nuclear battery. The nuclear battery module may also include a shield in the same manner.

As the shield, any known radiation-shielding member can be used, and the shield may be a typical radiation-shielding member made of lead, concrete, or the like, a rubber sheet having a radiation-shielding ability, or a resin sheet having a radiation-shielding ability.

The thermoelectric conversion element in the nuclear battery may be a single layer, or may be multi-layered to obtain a nuclear potential that gives a high electromotive force. A protective film may be provided to protect the thermoelectric conversion element, and the nuclear battery may be connected to terminals and used as a nuclear battery device.

The size and the shape of the nuclear battery can be determined as desired in accordance with the intended use.

Thus far, the nuclear battery of the present disclosure has been described in detail; however, the scope of the invention is not limited to the above-described examples, and various improvements and modifications may be made without departing from the gist of the invention.

For example, in the step S13 of the above-described embodiment, the external magnetic field B is applied to the ferromagnetic metal layer 203 in a direction that is an in-plane (XY planar) direction of the thermoelectric conversion element 200 and perpendicular to the flow direction of the heat flow H (see FIGs. 3 and 4); however, the external magnetic field B may be applied in a direction that is an in-plane (XY planar) direction of the thermoelectric conversion element 200 and intersects with the flow direction of the heat flow H at an angle other than 90°. It is noted here that the external magnetic field B and the heat flow H are set such that they are neither parallel nor antiparallel to each other.

Further, in the step S13 of the above-described embodiment, thermoelectric conversion is performed while applying the external magnetic field B (see FIG. 3 and FIG. 4); however, as long as the ferromagnetic metal layer 203 exhibits the magnetization 203M even in the absence of the application of the external magnetic field B, the thermoelectric conversion in the step S13 can be performed without applying the external magnetic field B. Examples of a method for realizing this include: constructing the ferromagnetic metal layer 203 using a material having a large coercive force so as to allow the ferromagnetic metal layer 203 to have the magnetization 203M as residual magnetization; and providing the thermoelectric conversion element 200 with a layer or member that applies a static magnetic field or exchange coupling magnetic field to the ferromagnetic metal layer 203. For example, the thermoelectric conversion element 200 may further include an antiferromagnetic layer of NiO, IrMn, FeMn, NiMn, PtMn, PdMn, Mn₂Au, FeRh, MnSb, or the like, which is stacked on the opposite side of the ferromagnetic metal layer 203 from the paramagnetic metal layer 205 such that it applies an exchange coupling magnetic field to the ferromagnetic metal layer 203. This makes it possible to perform thermoelectric conversion without applying the external magnetic field B.

In the above-described embodiment, the pair of electrodes 207a and 207b are arranged on a surface 205S of the paramagnetic metal layer 205 in such a manner that the electrodes 207a and 207b are not in contact with the ferromagnetic metal layer 203 and are apart from each other along the X-axis direction (see FIG. 3 and FIG. 4); however, the electrodes 207a and 207b may be arranged on the respective side surfaces of the paramagnetic metal layer 205 in the X-axis positive and negative directions in such a manner that the electrodes 207a and 207b are not in contact with the ferromagnetic metal layer 203 and are apart from each other along the X-axis direction.

In the above-described embodiment, the ferromagnetic metal layer 203 is a single layer (see FIG. 3 and FIG. 4); however, the ferromagnetic metal layer 203 may be composed of plural ferromagnetic metal layers that are stacked. In this case, it is preferred that each of the plural layers be formed of a Ni-Fe alloy, Fe, Co, Ni, Gd, a CoFeB alloy, or a (Ga,Fe)Sb alloy. Such plural ferromagnetic metal layers that are stacked may be, for example, a laminate in which layers formed of plural kinds of ferromagnetic metals are periodically stacked on each other (e.g., a laminate in which three kinds of layers are periodically stacked as in layer A, layer B, layer C, layer A, layer B, layer C, and so on, where a layer formed of a first ferromagnetic metal is defined as layer A, a layer formed of a second ferromagnetic metal is defined as layer B, and a layer formed of a third ferromagnetic metal is defined as l layer C), or a laminate in which layers formed of plural kinds of ferromagnetic metals are randomly stacked on each other (e.g., a laminate in which three kinds of layers are randomly stacked as in layer A, layer B, layer C, layer B, layer A, layer C, and so on).

Further, in the above-described embodiment, the paramagnetic metal layer 205 is a single layer (see FIG. 3 and FIG. 4); however, the paramagnetic metal layer 205 may be composed of plural paramagnetic metal layers that are stacked. In this case, it is preferred that each of the plural layers be formed of Pt, Pd, W, an AuW alloy, Ta, a CuIr alloy, a CuBi alloy, a BiSb alloy, or a BiSe alloy. Such plural paramagnetic metal layers that are stacked may be, for example, a laminate in which layers formed of plural kinds of paramagnetic metals are periodically stacked on each other (e.g., a laminate in which three kinds of layers are periodically stacked as in layer D, layer E, layer F, layer D, layer E, layer F, and so on, where a layer formed of a first paramagnetic metal is defined as layer D, a layer formed of a second paramagnetic metal is defined as layer E, and a layer formed of a third paramagnetic metal is defined as layer F), or a laminate in which layers formed of plural kinds of paramagnetic metals are randomly stacked on each other (e.g., a laminate in which three kinds of layers are randomly stacked as in layer D, layer E, layer F, layer E, layer D, layer F, and so on). The plural paramagnetic metal layers that are stacked preferably have spin Nernst angles of the same sign. This is because, during the thermoelectric conversion in the thermoelectric conversion layer 202, the non-reciprocal thermoelectric signals originating from the plural paramagnetic metal layers are thereby prevented from canceling out each other, so that the non-reciprocal thermoelectric signals can be enhanced as a whole.

In the above-described embodiment, the thermoelectric conversion layer 202 has only one paramagnetic metal layer (paramagnetic metal layer 205) (see FIG. 3 and FIG. 4); however, the thermoelectric conversion layer 202 may include a first paramagnetic metal layer and a second paramagnetic metal layer. In this case, the thermoelectric conversion layer 202 is configured by stacking the first paramagnetic metal layer, the ferromagnetic metal layer 203, and the second paramagnetic metal layer in this order along the Z-axis direction such that the ferromagnetic metal layer 203 is interposed between the first paramagnetic metal layer and the second paramagnetic metal layer. Preferred constituent materials for the first and second paramagnetic metal layers are the same as those for the paramagnetic metal layer 205, and the configurations (e.g., constituent materials and film thickness) of the first and second paramagnetic metal layers are selected such that the thermoelectric conversion layer 202 has a structure in which space inversion symmetry is broken along the Z-axis direction.

In this case, the first and second paramagnetic metal layers preferably have spin Nernst angles of the opposite signs from each other (this can be realized by, for example, constructing the first paramagnetic metal layer using Pt and the second paramagnetic metal layer using Ta). This is because, during the thermoelectric conversion in the thermoelectric conversion layer 202, spin currents having the same polarity are thereby injected from the first paramagnetic metal layer and the second paramagnetic metal layer into the ferromagnetic metal layer 203, so that the non-reciprocal thermoelectric signals can be enhanced.

Further, in this case, each or either of the first paramagnetic metal layer and the second paramagnetic metal layer may be composed of plural paramagnetic metal layers that are stacked as described above. In this case, for the same reasons as described above, the plural paramagnetic metal layers constituting each or either of the first paramagnetic metal layer and the second paramagnetic metal layer preferably have spin-Nernst angles of the same sign.

In the above-described embodiment, the pair of electrodes 207a and 207b are arranged on the surface 205S of the paramagnetic metal layer 205 (see FIG. 3 and FIG. 4); however, the pair of electrodes 207a and 207b may be arranged on the back surface (the surface on the Z-axis negative side) of the ferromagnetic metal layer 203 in such a manner that the electrodes 207a and 207b are not in contact with the paramagnetic metal layer 205 and are apart from each other along the X-axis direction.

In the above-described embodiment, the thermoelectric conversion layer 202 is configured by stacking the ferromagnetic metal layer 203 and the paramagnetic metal layer 205 in this order on a substrate 201 (see FIG. 3 and FIG. 4); however, the thermoelectric conversion layer 202 may be configured by stacking the paramagnetic metal layer 205 and the ferromagnetic metal layer 203 in this order on the substrate 201. In this case, the pair of electrodes 207a and 207b can be arranged on the surface (the surface on the Z-axis positive side) of the ferromagnetic metal layer 203 or the back surface (the surface on the Z-axis negative side) of the paramagnetic metal layer 205 in such a manner that the electrodes 207a and 207b are apart from each other along the X-axis direction.

The present invention will now be described in more detail by way of concrete Examples. It is noted here, however, that the present invention is not limited to the below-described Examples.

### [Production Example of Thermoelectric Conversion Element]

An element corresponding to the thermoelectric conversion element 200 of FIG. 3 was produced as follows. First, a 0.5 mm-thick Si substrate with a thermal oxide film was prepared as the substrate 201, and a 5 nm-thick Ni-Fe alloy layer as the ferromagnetic metal layer 203 and a 5 nm-thick Pt layer as the paramagnetic metal layer 205 were deposited in this order on the substrate by a DC magnetron sputtering method to form the thermoelectric conversion layer 202. Subsequently, by a photolithography method and a lift-off method, the thermoelectric conversion layer 202 was patterned into a rectangular shape in a plan view with a width of 5 µm in the Y-axis direction and a length of 50 µm in the X-axis direction. Thereafter, a Ti/Au layer was deposited on the thermoelectric conversion layer 202 by an RF magnetron sputtering method, and this Ti/Au layer was patterned into a prescribed shape by a photolithography method and a lift-off method to form a pair of electrodes corresponding to the pair of electrodes 207a and 207b, whereby an element corresponding to the thermoelectric conversion element 200 was produced.

### [Example 1]

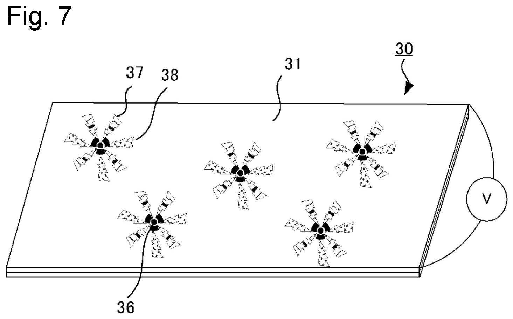

A nuclear battery conceptually illustrated in FIG. 7 is produced. Plutonium-238 is implanted on a sapphire substrate using an accelerator, and a Pt (5 nm) = Py (5 nm) bilayer film (thermoelectric conversion element) is formed by RF magnetron sputtering. This film is patterned into a rectangular device of 5 µm in width and 50 µm in length by electron beam lithography and Ar ion etching. The thus obtained nuclear battery is placed in a magnetic field at room temperature, and the non-linear voltage is measured.

### [Example 2]

A nuclear battery conceptually illustrated in FIG. 7 is produced. Curium-244 is implanted on a sapphire substrate using an accelerator, and a Pt (5 nm) = Py (5 nm) bilayer film (thermoelectric conversion element) is formed by RF magnetron sputtering. This film is patterned into a rectangular device of 5 µm in width and 50 µm in length by electron beam lithography and Ar ion etching. The thus obtained nuclear battery is placed in a magnetic field at room temperature, and the non-linear voltage is measured.

The thermoelectric conversion element produced in Example can generate a thermoelectric signal nonlinearly with respect to the direction of a temperature gradient, and is thus capable of performing thermoelectric conversion from temperature fluctuations at the microscale where a temperature gradient is substantially absent at the macroscale. Accordingly, the nuclear batteries of Examples 1 and 2, which contained a radioisotope in their constituents, can generate electrical energy from the heat of radiation randomly emitted from the radioisotope. Therefore, the nuclear battery of the present disclosure is lightweight and thin since, unlike conventional nuclear batteries, it does not require a member for forming a temperature gradient in the thermoelectric conversion element. In addition, since the nuclear battery of the present disclosure can perform thermoelectric conversion from temperature fluctuations at the microscale, not only it enables power generation from extremely weak radiation, but also the deterioration of the nuclear battery caused by radiation is extremely small. Therefore, the nuclear battery of the present disclosure can be put into practical use in the fields of radiation therapy power sources, space exploration power sources, power generators for military equipment, traffic signal power generation, and nuclear power (e.g., power generation from spent nuclear fuel casks).

The present invention has been described above in detail referring to concrete Examples; however, it is obvious to those skilled in the art that various modifications and changes can be made without departing from the spirit and the scope of the present invention.

### [Additional Note]

The nuclear battery of the present disclosure not only is lightweight and can be made compact but also has a high power generation efficiency as compared to existing nuclear batteries. Therefore, the nuclear battery of the present disclosure can contribute to Goal 9 of the Sustainable Development Goals (SDGs) led by the United Nations.
- Goal 9: "Build resilient infrastructure, promote inclusive and sustainable industrialization, and foster innovation"

### REFERENCE SIGNS LIST

10, 20, 30: Nuclear battery
11, 21, 31: Paramagnetic metal layer
12, 22: Ferromagnetic metal layer
13, 23: Thermoelectric conversion element
14, 24: Electrode
25: Substrate
16, 26, 36: Radioisotope
37: Heat
38: Radiation
200: Thermoelectric conversion element
202: Thermoelectric conversion layer
203: Ferromagnetic metal layer
205: Paramagnetic metal layer
207a, 207b: Pair of electrodes
300: Thermoelectric conversion module

## Claims

1. A nuclear battery, comprising a thermoelectric conversion element provided with:
a thermoelectric conversion unit exhibiting non-reciprocal conduction based on breakage of space inversion symmetry; and
a pair of electrodes for extracting a non-reciprocal thermoelectric signal, that are arranged apart from each other on the thermoelectric conversion unit
at least one constituent of the nuclear battery containing a radioisotope element.

2. The nuclear battery according to claim 1, wherein
the thermoelectric conversion unit is a thermoelectric conversion layer including a ferromagnetic metal layer and a paramagnetic metal layer that are stacked on each other, and
the pair of electrodes are arranged apart from each other on the thermoelectric conversion layer in an in-plane direction of the thermoelectric conversion layer.

3. The nuclear battery according to claim 2, wherein the separation distance between the pair of electrodes is 0.1 µm or more and 1,000 µm or less.

4. The nuclear battery according to claim 2, wherein
the paramagnetic metal layer is composed of a single layer or plural stacked layers, and
the single layer or each of the plural stacked layers of the paramagnetic metal layer is composed of Pt, Pd, W, an AuW alloy, Ta, a CuIr alloy, a CuBi alloy, a BiSb alloy, or a BiSe alloy.

5. The nuclear battery according to claim 2, wherein
the ferromagnetic metal layer is composed of a single layer or plural stacked layers, and
the single layer or each of the plural stacked layers of the ferromagnetic metal layer is composed of a Ni-Fe alloy, Fe, Co, Ni, Gd, a CoFeB alloy, or a (Ga,Fe)Sb alloy.

6. The nuclear battery according to claim 1, wherein the radioisotope element contains at least one element selected from the group consisting of beryllium-10, carbon-14, aluminum-26, silicon-32, chlorine-36, argon-39, potassium-40, nickel-63, selenium-79, rubidium-87, zirconium-93, indium-115, cesium-137, lanthanum-138, niobium-94, technetium-98, lutetium-71, neodymium-144, samarium-146, samarium-147, gadolinium-152, platinum-190, bismuth-210, polonium-209, thorium-232, uranium-232, uranium-233, uranium-234, uranium-235, uranium-236, uranium-238, plutonium-236, plutonium-238, plutonium-239, plutonium-244, americium-241, americium-243, curium-244, curium-246, curium-247, curium-248, californium-249, and californium-251.

7. A nuclear battery module, comprising plural nuclear batteries according to any one of claims 1 to 6,
wherein the plural nuclear batteries are electrically connected to each other such that non-reciprocal thermoelectric signals from the respective nuclear batteries can be superimposed with the same polarity.
